Europäisches Patentamt

European Patent Office

Office européen des brevets

(11) Publication number: **0 429 664 A1**

# EUROPEAN PATENT APPLICATION
## published in accordance with Art. 158(3) EPC

(21) Application number: 90908642.3

(22) Date of filing: 06.06.90

(86) International application number:
PCT/JP90/00736

(87) International publication number:
WO 90/16141 (27.12.90 90/29)

(51) Int. Cl.⁵: **H05K 3/34, H05K 1/02**

(30) Priority: 16.06.89 JP 155066/89

(43) Date of publication of application:
05.06.91 Bulletin 91/23

(84) Designated Contracting States:
**DE FR GB Bulletin**

(71) Applicant: **FUJITSU LIMITED**
**1015, Kamikodanaka Nakahara-ku**
**Kawasaki-shi Kanagawa 211(JP)**

(72) Inventor: **GOTO, Masanori 2-12-8-404, Taira**
**Miyamae-ku**
**Kawasaki-shi**
**Kanagawa 213(JP)**

(74) Representative: **Joly, Jean-Jacques et al**
**CABINET BEAU DE LOMENIE 55, rue**
**d'Amsterdam**
**F-75008 Paris(FR)**

(54) **PRINTED CIRCUIT BOARD AND METHOD OF MOUNTING CIRCUIT PARTS.**

(57) A printed circuit board (2) provided with heating pads (14) which are formed outside the region for mounting circuit parts (1) and connected to connection pads (3-1). A method of mounting circuit parts wherein in temporarily fastening circuit parts (1) to a printed circuit board (2), heat is applied from outside the region for mounting the circuit parts (1), and the solder on the connection pads (3-1) is indirectly melted.

Fig. 1A

## PRINTED CIRCUIT BOARD AND ELEMENT MOUNTING METHOD

[Field of the Invention]

The present invention relates to a printed circuit board which is widely used for circuit structures of various electronic devices.

[Background of the Invention]

With improvement in high packing and integrating density, recent circuit elements are is particularly increasng in input and output terminals and are also changing, in the shape of package, to leadless package from outer lead package. Meanwhile, in case a circuit element (herein after referred to as package) is mounted on a printed circuit board, temporary fixing must be done to prevent displacement of junction. Therefore, a new type printed circuit board, which can temporarily fix the input and output terminals of circuit element based on alteratin of circuit element, has been required.

As a method of temporary fixing, a method of fixing by soldering the input and output terminals of package and connection pads on the printed circuit board is known as the most excellent method from the point of view of reliability and junction strength.

In the case of the outer lead package, the solder between the connecting pad and input and output terminals is fused with direct application of the solder iron or irradiatin of laser beam from the outside of package. For example, the package can be fixed temporarily by selecting such fusing points to the four corners of package.

Meanwhile, in the case of an inner lead package, since such direct application of solder iron or irradiation of laser beam to the input and output terminals is impossible, temporary fixing has been conducted utilizing viscocity of flux applied between the input and output terminals and connecting pad or a guide frame surrounding the external side of package which may be inferior in reliability and junction strength to the soldering method.

However, if flux is used for temporary fixing of inner lead package, positioning becomes difficult. Therefore, deteriorated working efficiency and generation of displacement of package will deteriorate reliability of junction.

Moreover, use of guide frame will deteriorate reliability of junction, if impact is applied, due to displacement of package together with the guide frame.

[Disclosure of the Invention]

Considering such problems, it is therefore an object of the present invention to provide a new type printed circuit board which has simplified the connecting pad of printed circuit board and input andoutput terminals of circuit elements and also improved reliability of junction.

The present invention provides a structure that at least a couple of heating pads for heating solder bump of package are provided at the outside of package size on a printed circuit board arranging connecting pads to be connected with solder bump of package.

The most distincitive characteristic of the present invnetion is that the solder is fused for indirect connection of connecting pad from the outside of package by connecting the heating pad to the connected pad to be connected with the input and output terminals for temporary connection.

[Brief Description of the Drawings]

Fig. 1 shows a printed circuit board as a first embodiment of the present invention.

Fig. 1A is a perspective view and Fig. 1B is a sectional view of the essential portion.

Fig. 2 is a perspective view indicating a printed circuit board as a second embodiment of the present invention.

Fig. 3 is a sectional view indicating temporary fixing by the first embodiment of the present invention.

Fig. 4 is a perspective view indicating the conventional printed circuit board.

Fig. 5 is a sectional view indicating mounting of the conventional package.

Fig. 5A is a diagram using flux.

Fig. 5B is a diagram using a guide frame.

[Preferred Embodiment of the Invention]

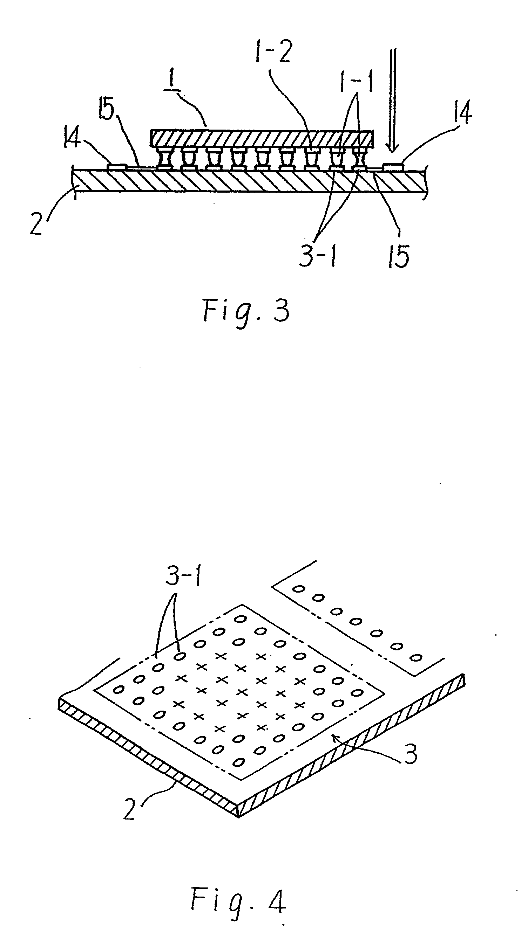

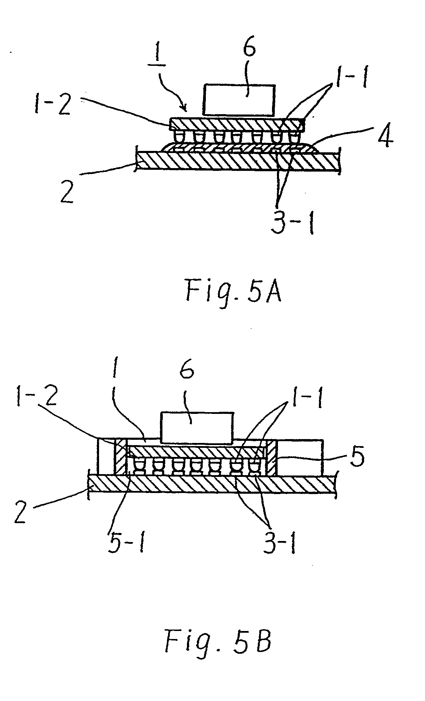

A printed circuit board on which the present invention is based will be explained first with reference to Fig. 4 and Fig. 5.

Fig. 4 is a perspective view of the conventional printed circuit board. Fig. 5 is a sectional view indicating the conventional package mounting method. Fig. 5A is a diagram using flux and Fig. 5B is a diagram using a guide frame.

The printed circuit board which has been used widely has a structure that the connecting pads 3-1 to be connected with solder bumps are formed on the main surface of the printed circuit board 2 at the position opposed to such solder bumps with fine pitch arranged in the connecting side of package as shown in Fig. 4, a foot pattern 3 of 17 corners, for example, is formed and such foot patterns are arranged in the form of matrix with a constant pitch, for example, of 21 mm.

For the mounting of package 1, a half-mirror not illustrated is inserted, from the side surface of package 1, between the package 1 and printed circuit board 2 as shown in Fig. 5A, the package 1 is placed on the connecting pads 3-1 coated at the surface thereof with the flux 4 and these are pressed with a weight 6 after visually aligning the solder bumps 1-1 of package 1 and connecting pads 3-1 of the printed circuit board 2 and soldering has been conducted by inserting the package and printed circuit board into the vapor solder bath under the condition that the positioning is maintained with viscocity of flux 4.

Moreover, as shown in Fig. 5B, a guide frame 5 boring square holes 5-1 in such a size, for example, of 17 mm as allowing insertion of package 1 to the position corresponding to the foot patterns arranged on the printed circuit board 2 is place to surround the foot patterns arranged in the side of main surface of the printed circuit board 2 and it is soldered in the vapor solder bath by inserting package 1 into the respective square holes 5-1 under the condition that the guide frame is pressed by a weight 6.

The conventional printed circuit board explained above results in a problem that alignment of connecting pads 3-1 and package 1 is carried out using a half-mirror during mountinmg of the package as shown in Fig. 5A and the positioning is maintained with viscosity of flux 4 applied on the surface of the connecting pads 3-1a, making difficult the positioning. Thereby, working effiency is deteriorated and displacement of package 1 is generated, also resulting in deterioration of reliability of junction.

Moreover, since the positioning is carried out, as shown in Fig. 5B, by placing the guide frame 5 of package 1 on the printed circuit board 2 and then inserting the package 1 into the square holes 5-1 thereof, a problem rises here that if even a small impact is applied to the printed circuit board 2, the package 1 displaces together with the guide frame 5 and reliability of junction is deteriorated.

The printed circuit board and circuit element mounting structure of the present invention have solved the problems described above.

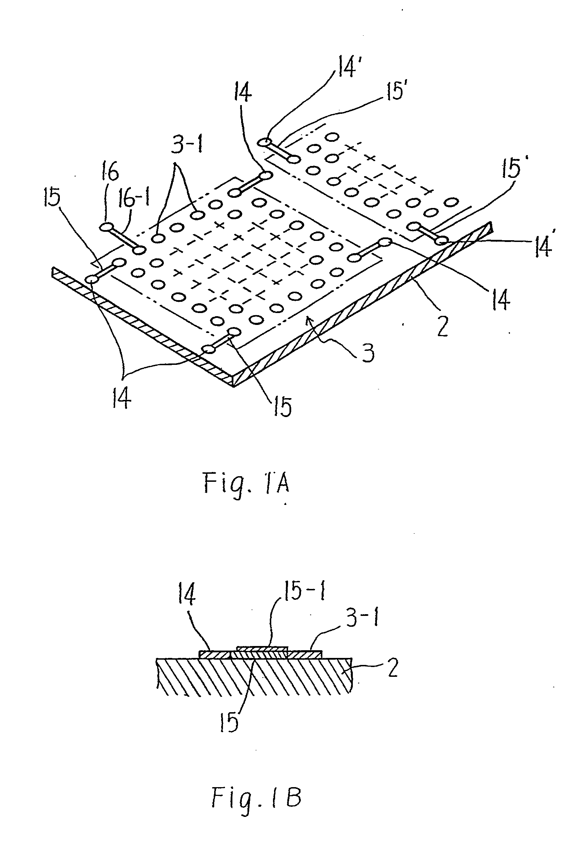

A preferred embodiment of the present invention shown in Fig. 1, Fig. 2 and Fig. 3 will be explained in detail.

Fig. 1 is a diagram indicating a printed circuit board as a first embodiment of the present invention. Fig. 1A is a perspective view and Fig. 1B is a sectioanl view of the essential portion.

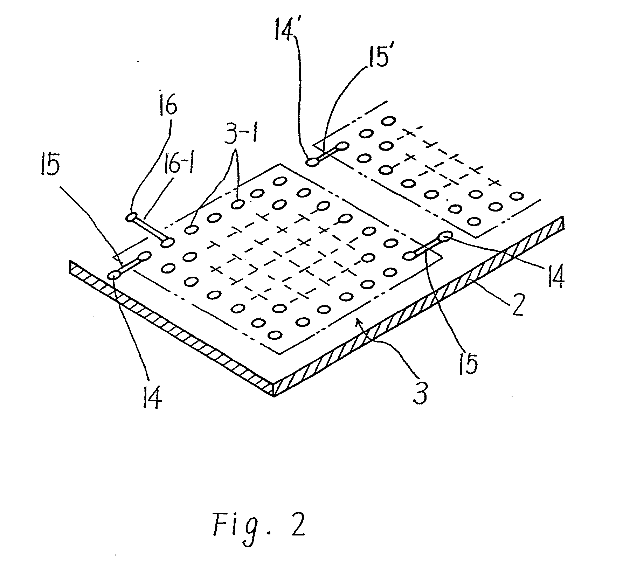

Fig. 2 is a perspective view indicating a printed circuit board as a second embodiment of the present invention.

Fig. 3 is a sectional view indicating the temporary fixing by the first embodiment of the present invention.

The like referfence numerals indicate the like members throughout these drawings.

In the printed circuit board of the present invention, the connecting pads 3-1 to be joined with the solder bumps are formed like a matrix, just like the prior art, at the main surface of the printed circuit board 2 in the position opposed to the solder bump of package as shown in Fig. 1A, the heating pads 14 in the size almost equal to the connecting pads 3-1 are also provided in the vicinity of the connecting pads 3-1, for example, at the four corners of each foot pattern 3, and such heating pads 14 and connecting pads 3-1 to be fixed temporarily are connected with a heat transmitting pattern having excellent heat conductivity. As shown in Fig. 1B, the surface of heat conductive pattern 15 is coated with solder dam 15-1, for example, solder resist in order to prevent flow of solder fused on the connecting pads 3-1 into the heating pads 14.

In the method of temporarily fixing the package to such printed circuit board, as shown in Fig. 3, the solder bumps 1-1 are positioned to the connecting pads 301 of the printed circuit board 2 and the heating pads 14 are heated by irradiation of beam such as laser beam in the direction of arrow mark from the outside of the package 1. Thereby, temperature of connecting pads 3-1 connected wit the heatind pads 14 through the heat conductive paterns 15 having excellent heat conductivity rises and the solder bumps 1-1 in contact with the connecting pads 3-1 are fused for joining. In this case, since these are self-aligned with the surface tension of fused solder, temporary fixing is carried out by correcting relative position between the connecting pads 301 a little displaced at the time of positioning and the solder bump 1-1, and thereafter the connecting pads 301 of printed circuit board 2 are packages 1 are coupled in the vapor solder bath.

As a result, the package 1 is temporarily fixed to the respective foot patterns 3 formed on the printed circuit board 2 and thereby displacement during coupling of package can be prevented.

The reference numeral 16 in Fig. 1A designates EC pad, which is an extension pad for design change or modification and 16-1, a trace for connecting the EC pad 16 and the connecting pad 3-1.

As shown in Fig. 1A, the heating pads 14 connected to the particular connecting pad 301 through the heat conductive pattern 15 formed protruded to outside from the foot pattern 3 and the protruding direction is alternately changed for each line in zig-zag for the heat conductive pattern 15' and heating pad 14' protruded from the foot pattern 1 of the adjacent packages 1. By alternately changing protruding direction for each line, the mounting distance between foot patterns can be interporated and thereby high density packing can be realized.

The heat conductive pattern 15 is formed as follow. First, chromium (Cr), titanium (Ti) and copper (Cu) are sequentially formed by the sputter process from the surface of printed circuit board 2, and moreover copper (Cu), nickel (Ni) and gold (Au), as required, are also sequentially formed as the upper layers by the plating process.

This process is the same as the trace 16-1 and therefore the heat conductive pattern 15 and trace 16-1 can be formed simultaneously in the same procedures.

The heating pad 14 is also formed simultaneously with the connecting pads 301 and EC pad 16 explained previously in the same procedure, for example, the printing method.

Fig. 2 is a perspective view indicating a second embodiment of the present invention.

This is different from the first embodiment explained previously in such a point that the temporary fixing points are selected to a couple of connecting pads 3-1 on the diagonal of foot pattern.

It is adequately selected from the situation whether four points should be considered for temporary fixing like the first embodiment or two points should be considered like the second embodiment.

While the present invention has been explained with reference to the embodiment based on the accompanying drawings, but the present invention is not limited only thereto and allows various changes or modifications. Namely, as a solder dam, a metal plating which does not react with solder such as chromium may be provided at the surface of heading pad 14 and heat conductive pattern 15.

As is obvious from the above explanation, the present invention provides a printed circuit board which easily realizes temporary fixing of package with a very simplified structure and ensures remarkable effect in economization and imrovement in reliability..

[Industrial Applicability]

The printed circuit board and method of mounting circuit elements by the present invention can be applied to any type of the printed circuit board and particularly applicable with high effectiveness to the printed circuit board mounting circuit elements providing the protruded input and output terminals from the rear surface of package or circuit elements where solder bumps are formed at the rear surface of package.

List of Reference Numerals

| 1 | Package |
| 1-1 | Solder Bump |
| 1-2 | Terminal |
| 2 | Printed Circuit Board |
| 3 | Foot Pattern |
| 3-1 | Connecting Pad |
| 14 | Heating Pad |
| 15 | Heat Conductive Pattern |
| 15-1 | Solder Dam |
| 16 | EC Pad |
| 16-1 | Trace |

**Claims**

1. A printed circuit board providing connecting pads to be connected with the terminals formed to circuit elements comprising heating pads which are connected with said connecting pads and are formed at the outside of mounting region of said circuit elements.

2. A printed circuit board according to claim 1, wherein said circuit elements are inner lead type circuit elements.

3. A printed circuit board according to claim 2, wherein said connecting pads and heating pads are connected by heat conductive pattern which conducts heat applied to said heating pads to the side of said connecting pads.

4. A printed circuit board according to claim 3, wherein a solder dam which prevents flow of fused solder is formed at the surface of said heat conductive pattern.

5. A printed circuit board according to claim 4, wherein said heat conductive pattern is formed by the same material as a pattern for modification wired on said printed circuit board.

6. A method of mounting circuit elements for temporarily fixing circuit elements on the printed circuit board by soldering a part of terminals of circuit elements corresponding to the connecting pads on the printed circuit board, characterized in that The terminals and connecting pads are solder-connected by fusing indirect the solder from the outside of mounting region of circuit elements by applying the heat to the heating pads located at the outside of mounting region of circuit elements and connected to a part of connecting pads, and thereby the circuit elements are temporarily fixed on the printed circuit board.

AMENDED CLAIMS

1. (After amendment)
   A printed circuit board providing a plurality of connecting pads to be connected with a plurality of terminals formed on circuit elements, comprising heating pads which are connected with said connecting pads used for temporarily fixing said circuit elements, on the occasion of temporarily fixing said circuit elements on said printed circuit board, and are formed at the outside of the mounting region of said circuit elements.

2. A printed circuit board according to claim 1, wherein said circuit elements are inner lead type elements.

3. (After amendment)
   A printed circuit board according to claim 2, wherein the connecting pads use for temporarily fixing said circuit elements and said heating pads are connected through a heat conducting pattern which conducts heat applied to said heating pads to the side of connecting pads used for temporarily fixing said circuit elements.

4. A printed circuit board according to claim 3, wherein a solder damp for impeding flow of melted solder is formed at the surface of said heat conducting pattern.

5. A printed circuit board according to claim 4, wherein said heat conducting pattern is structured by the material similar to the pattern for modification wired on said printed circuit board.

6. (After amendment)
   A method of mounting circuit elements for temporarily fixing circuit elements on the printed circuit board by connecting, by solder, the terminals of circuit elements to the corresponding connecting pads used when the circuit elements on the printed circuit board are fixed temporarily, wherein the solder is indireclty melted from the outside of mounting region of the circuit elements, said terminals are connected by soldering with the connecting pads used for temporarily fixing said terminals and said circuit elements and thereby the circuit elements may be fixed temporarily on the printed circuit board by applying heat to the heating pads connected to the connecting pads which are formed at the outside of mounting region of circuit elements to be used for temporarily fixing said circuit elements.

Fig. 1A

Fig. 1B

Fig. 2

Fig. 3

Fig. 4

Fig. 5A

Fig. 5B

# INTERNATIONAL SEARCH REPORT

International Application No  PCT/JP90/00736

**I. CLASSIFICATION OF SUBJECT MATTER** (if several classification symbols apply, indicate all) *

According to International Patent Classification (IPC) or to both National Classification and IPC

Int. Cl$^5$   H05K3/34, H05K1/02

**II. FIELDS SEARCHED**

| Minimum Documentation Searched [7] | |
|---|---|
| Classification System | Classification Symbols |
| IPC | H05K3/34, H05K1/02, H01L21/60 |

Documentation Searched other than Minimum Documentation
to the Extent that such Documents are Included in the Fields Searched [8]

Kokai Jitsuyo Shinan Koho    1971 - 1990

**III. DOCUMENTS CONSIDERED TO BE RELEVANT [9]**

| Category * | Citation of Document, [11] with indication, where appropriate, of the relevant passages [12] | Relevant to Claim No. [13] |
|---|---|---|
| Y | JP, A, 60-163495 (Canon Inc.), 26 August 1985 (26. 08. 85), Pages 1 to 3 (Family: none) | 1-4, 6 |
| Y | JP, U, 58-32669 (Daini Seihosha K.K.), 3 March 1983 (03. 03. 83), Page 1 (Family: none) | 1 - 3 |
| A | JP, A, 60-62191 (NEC Corp.), 10 April 1985 (10. 04. 85), Pages 1 & 3 (Family: none) | 6 |
| A | JP, Y2, 63-28618 (Mitsubishi Electric Corp.), 2 August 1988 (02. 08. 88), Pages 1 & 3 (Family: none) | 1 - 5 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| August 18, 1990 (18. 08. 90) | September 3, 1990 (03. 09. 90) |
| International Searching Authority | Signature of Authorized Officer |
| Japanese Patent Office | |

Form PCT/ISA/210 (second sheet) (January 1985)